# EUROPEAN PATENT APPLICATION

(11) **EP 1 367 803 A2**
(43) Date of publication of application: **03.12.2003**
(21) Application number: 03090166.4
(22) Date of filing: 30.05.2003
(51) Int. Cl.: H04M 1/02, H04B 1/38

(54) **Arrangement for reducing of electromagnetic interferences in a circuit by connecting the conductive cover of a battery at plurality of locations to the ground-layer**

(30) Priority: 30.05.2002 JP 2002156577
(71) Applicant: NEC CORPORATION, Tokyo (JP)
(72) Inventor: Kuriyama, Toshihide, NEC Corporation, Tokyo (JP); Hankui, Eiji, NEC Corporation, Tokyo (JP); Kobayashi, Naoki, NEC Corporation, Tokyo (JP); Yamashita, Masayoshi, NEC Saitama Ltd., Kodama-gun, Saitama (JP)
(74) Representative: Patentanwälte Wenzel & Kalkoff

(57) **Abstract**

In a portable telephone (1) having a rechargeable battery, an electrically conductive outer cover of the rechargeable battery is connected at a plurality of locations (8) to a ground layer of a circuit board provided within the portable telephone, to reduce electromagnetic interferences in a circuit.

## Description

### BACKGROUND OF THE INVENTION

### 1. Field of the Invention

The present invention relates to a portable telephone, and more particularly to a portable telephone having a rechargeable battery as a power source.

### 2. Description of the Prior Art

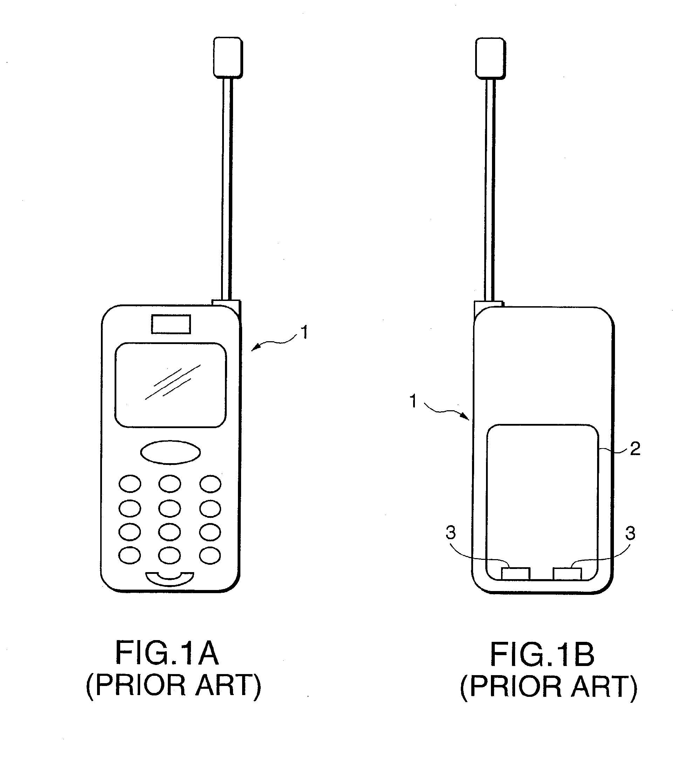

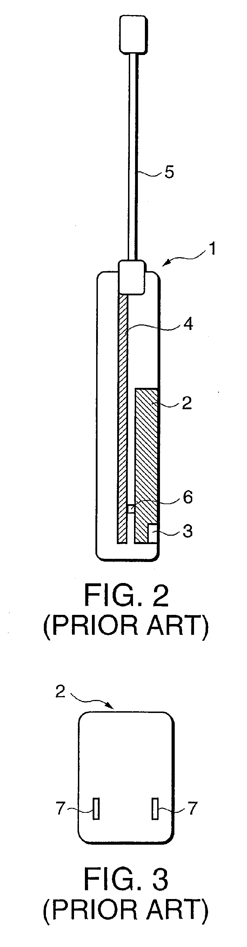

A conventional portable telephone or cellular phone having a rechargeable battery as a power source will be described with reference to FIG. 1A, FIG. 1B, FIG. 2 and FIG. 3. In these figures a rechargeable battery 2 having recharging terminals 3 is mounted on a rear surface of the portable telephone 1. The rechargeable battery 2 is provided in a casing of a body of the portable telephone 1 and supplies electric power to a circuit board 4 such as printed multilayered circuit board, which includes a radio circuit, a receiving circuit, a transmitting circuit and a control circuit, etc., mounted thereon, through a pair of power source pins 6. Further, an antenna 5 is connected to the radio circuit of the circuit board 4.

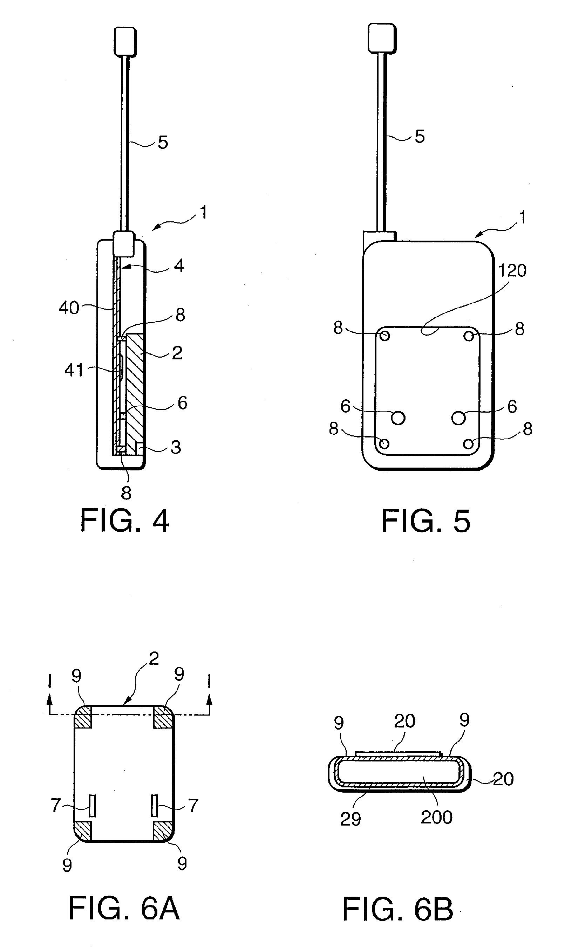

In general, the rechargeable battery is detachably mounted in the body of the portable telephone for the purpose of battery exchange such that the rechargeable battery 2 constitutes a portion of the casing of the portable telephone when mounted therein. As reflected by Fig. 3, a pair of power source terminals 7 for supplying power to the circuit board is also provided on the rechargeable battery 2. A surface area of the rechargeable battery other than the power source terminals is covered by an insulating resin film.

In the conventional portable telephone mentioned above, radio waves are generated by predetermined high frequency current in the antenna 5. In order to reduce the overall size of the portable telephone, the antenna 5 is made shorter than half of the wavelength at a predetermined frequency. Therefore, high frequency current flows in not only the antenna 5 but also the circuit board 4. When the rechargeable battery 2 is electrically connected to the circuit board 4 through the power source pins 6, the rechargeable battery 2 and the circuit board 4 opposing the rechargeable battery 2 form a parallel flat structure with the power source pins 6 as short-circuiting points. Therefore, high frequency current or antenna current in the circuit board 4 is reflected by the power source pins 6 and the reflected high frequency current is further reflected by an inlet of the high frequency current to the circuit board. Consequently, high frequency current exists in a portion of the circuit board, which is defined between the circuit board and the rechargeable battery as a standing wave, causing high frequency current to be increased substantially. A large amount of high frequency current flowing through the circuit board 4 may be branched to an LSI provided on the circuit board 4 in the area defined between the circuit board 4 and the rechargeable battery 2, leading to malfunction of the LSI. For example, it may happen that voice quality in talking performed by the telephone is degraded due to pulse noise in a voice signal, which is generated by high frequency current strayed from the circuit board into the LSI constituting the receiving circuit.

### SUMMARY OF THE INVENTION

An object of the invention is to provide a portable telephone, which can prevent an LSI provided on a circuit board in the portable telephone from malfunctioning by transmitting high frequency current increased by a rechargeable battery and can provide a good communication performance.

The portable telephone including a rechargeable battery, according to the invention, is featured by the rechargeable battery having an electrically conductive outer cover grounded at a plurality of locations to a ground layer of a circuit board provided within a casing of the portable telephone. Particularly, it is preferable that a plurality of grounding terminals is provided on the electrically conductive outer cover of the rechargeable battery and the grounding terminals are arranged in a peripheral portion of the rechargeable battery. Alternatively, the grounding terminals may be arranged at or in the vicinity of four corners of the rechargeable battery.

Further, the rechargeable battery may be detachable from the portable telephone and a plurality of grounding pins connected to the ground layer of the circuit board may be provided such that the grounding pins are in contact with the plurality of the grounding terminals provided on the electrically conductive outer cover of the rechargeable battery.

In the portable telephone according to the invention in which the electrically conductive outer cover of the rechargeable battery is connected to the ground layer of the circuit board at the plurality of locations, high frequency current of the circuit board flows through the outer cover of the rechargeable battery, so that high frequency current of the circuit board on which the LSI is mounted in an area thereof defined between the circuit board and the rechargeable battery is substantially reduced.

### BRIEF DESCRIPTION OF THE DRAWINGS

FIG. 1A is a front view of a conventional portable telephone;
FIG. 1B is a rear view of the portable telephone shown in FIG. 1A;
FIG. 2 is a cross sectional view of the conventional portable telephone;
FIG. 3 is a plan view of a conventional rechargeable battery;
FIG. 4 is a cross section of a portable telephone according to an embodiment of the present invention;
FIG. 5 is a rear view of the portable telephone of the present invention, showing a plan view of a battery housing with a battery being detached;
FIG. 6A is a plan view of a surface of a rechargeable battery faced opposing to a circuit board; and
FIG. 6B is a cross section taken along a line I-I in FIG. 6A.

### DETAILED DESCRIPTION OF THE PREFERRED EMBODIMENTS

An embodiment of the invention will be described with reference to the drawings. For simplicity of illustration, the display portion and operation buttons are omitted.

In FIG. 4, the circuit board 4 is a multi-layered printed circuit provided with a ground layer 40 inside. An integrated circuit element 41 such as LSI, etc., is mounted on the circuit board 4. The circuit board 4 is electrically connected to an antenna 5 and a rechargeable battery 2. The circuit board 4 and the rechargeable battery 2 are electrically connected to each other through a pair of power source pins 6 and a plurality of grounding pins 8. Further, a pair of charging terminals 3 is provided on the rechargeable battery.

In Fig. 5 the grounding pins 8 are provided in the vicinity of four corners of a bottom surface of the battery receiving portion, respectively, and the power source pins 6 are provided on the bottom surface of the battery receiving portion. These pins 6 and 8 are electrically connected to the circuit board 4 through holes provided on the bottom surface of the battery receiving portion made of insulating material.

As shown in FIG. 6A and FIG. 6B, the rechargeable battery of the portable telephone of the invention includes a flat rectangular battery portion 200, which may be a lithium ion battery, a metal cover 29 of the battery portion 200 and an insulating film 20 covering the metal cover 29. Four corner portions of the insulating film 20 on the metal cover 29 on the side of the circuit board are removed to expose corresponding portions of the metal cover 29 corresponding in position to the respective grounding pins 8 shown in FIG. 5. Further, the rechargeable battery 2 also has a pair of power source terminals 7. On the circuit board 4, a radio circuit electrically connected to the antenna 5, a receiving circuit, a transmitting circuit and a control circuit, etc., which are well known, are mounted (not shown).

When the rechargeable battery 2 having the recharging terminals 3 is received in the battery receiving portion 120, the second battery 2 supplies electric power to the circuit board 4 through the power source terminals 7 and the power source pins 6. Simultaneously therewith, the grounding terminals 9 constituted by the exposed portions of the metal cover 29 of the rechargeable battery portion 200 are connected to the ground layer 40 of the circuit board 4 through the grounding pins 8 provided on the side of the bottom of the battery receiving portion 120 of the portable telephone 1.

In this construction, high frequency current in the antenna 5 and the circuit board 4 flows to the metal cover 29 of the rechargeable battery 2 through the grounding pins 8 and the grounding terminals 9, so that such high frequency current does not flow into a portion of the circuit board 4, which is defined between the circuit board 4 and the rechargeable battery. Therefore, high frequency current in the portion of the circuit board 4, which is defined between the circuit board and the rechargeable battery, is substantially reduced, compared with the conventional portable telephone in which high frequency current exists in the circuit board as a standing wave. This is because the electrically conductive outer cover 29 of the rechargeable battery 2 connected at the plurality of locations to the ground of the circuit board 4 constitutes a shield structure. Therefore, the flow of high frequency current into the LSI provided on the portion of the circuit board 4, which is defined between the circuit board 4 and the rechargeable battery 2, is prevented, so that malfunction of the LSI is prevented.

As for the electrically conductive outer cover of the present invention, the type of metal used for the negative electrode of the battery can be used. In that case, the ground layer of the circuit board can be electrically connected to the electrically conductive outer cover of the battery through the electrical conductive member in a direct current (D.C.) mode.

When the electrically conductive outer cover of the battery is made of the metal common to the positive electrode of the battery, the electrically outer cover of the battery cannot be connected to the ground layer of the circuit board. To avoid short circuiting between the ground circuit and the outer cover, the metal for the positive electrode can be electrically connected to the ground layer through a dielectric material in a high frequency coupling or radio frequency coupling manner. To this end, the grounding pins 8 shown in FIG. 4 should be removed and the bottom portion of the battery receiving portion which is made of insulating material is used as an dielectric member to achieve high frequency coupling between the ground layer and the outer cover common to the positive electrode.

According to the invention, the outer cover of the battery is not necessarily connected to the negative electrode or positive electrode. Typical material for the outer cover of the battery of the invention is selected from one of such metal as aluminum, iron and stainless steel.

The invention is not limited to the described embodiment in which the invention is applied to the portable telephone of one box type. The invention can be applied to a folding telephone. In the latter case, it is enough that the grounding terminals provided in the peripheral portion of the electrically conducive outer cover of the rechargeable battery provided in one of two body portions of the folding type portable telephone are grounded at a plurality of locations to a ground layer of a circuit board provided within the body portion of the portable telephone, through the grounding pins.

In the above-description, the grounding points are located at four corners. However, according to the invention, since the suppressing effect for reducing an antenna current running through the ground layer of the circuit board can be achieved by providing at least two grounding points along a longitudinal direction of the circuit board, the scope of the present invention cannot be restricted the embodiments shown in the drawings. When the number of the grounding points is increased, the above-stated suppressing effect can be increased and thus the number of the grounding points may be six or eight in total along the peripheral region. In view of cost saving, four corner grounding points shown in the embodiment of the invention is appropriate.

As described above, according to the invention, a malfunction of an active device such as an LSI provided between a circuit board and a rechargeable battery is prevented, resulting in a good communication performance of the portable telephone. This is because high frequency current in the portion of the circuit board 4 between the circuit board and the rechargeable battery 2 is substantially reduced and, as a result thereof, the flow of high frequency current into the LSI provided on the portion of the circuit board 4 in an area between the circuit board and the rechargeable battery is restricted.

## Claims

1. A portable telephone comprising:
a telephone body having a circuit board;
a casing of said telephone body; and
a battery arranged within said casing and having an electrically conductive outer cover grounded at a plurality of locations to a ground layer of said circuit board.

2. A portable telephone as claimed in claim 1, wherein said electrically conductive outer cover of said battery includes a plurality of grounding terminals arranged in a peripheral portion of said battery.

3. A portable telephone as claimed in claim 1, wherein said electrically conductive outer cover of said battery includes a plurality of grounding terminals arranged in four corners of said battery.

4. A portable telephone as claimed in claim 1, wherein said electrically conductive outer cover of said battery includes a plurality of grounding terminals arranged in the vicinity of four corners of said battery.

5. A portable telephone as claimed in claim 1, wherein said battery is detachably housed in said casing of said portable telephone and a plurality of grounding pins connected to said ground layer of said circuit board is provided such that said grounding pins become in contact with the plurality of said grounding terminals provided on said electrically conductive outer cover of said battery, respectively.

6. A portable telephone as claimed in claim 1, wherein said ground layer is electrically connected to said electrically-conductive outer cover through an electrical conductive member in a direct current coupling manner.

7. A portable telephone as claimed in claim 1, wherein said ground layer is electrically connected to said electrically conductive outer cover through a dielectric member in a high frequency coupling manner.

8. A portable telephone as claimed in claim 1, wherein said battery is a rechargeable battery.
